# EUROPEAN PATENT SPECIFICATION

(11) **EP 0 684 906 B1**
(45) Date of publication and mention of the grant of the patent: **21.11.2001**
(21) Application number: 93916386.1
(22) Date of filing: 19.02.1993
(51) Int. Cl.: B32B 17/02, B32B 17/04, G02B 6/00, G02B 6/14, C08F 2/50, C08G 18/32, C08G 18/42, C08G 18/44, C08G 18/46, C08G 18/48, C08G 18/67, C09D 175/14

(54) **LIQUID CURABLE RESIN COMPOSITION**
FLÜSSIGE, HÄRTBARE HARZZUSAMMENSETZUNG
COMPOSITION LIQUIDE DE RESINE, DURCISSABLE

(43) Date of publication of application: 06.12.1995
(73) Proprietor: DSM N.V., 6411 TE Heerlen (NL)
(72) Inventor: OHTAKA, Tohru, Hakusan 4-1-3, KawasakiCity, Kanagawa 215 (JP); HASHIGUCHI, Yuichi, JSR Apartment 1-206, Kanagawa 227 (JP); SUWA, Mitsuhito, JSR Aoba Apartment, 2-29,Aobadai, Kanagawa 227 (JP); IGARASHI, Katutoshi, JSR Apartment, 2-201,Aobadai, Kanagawa 227 (JP)
(86) International application number: US9300995
(87) International publication number: WO9419185

(56) References cited:
- EP-A- 0 193 092
- WO-A-91/03499
- FR-A- 2 303 835
- GB-A- 2 163 755
- US-A- 4 608 409
- US-A- 4 624 994
- US-A- 4 843 111
- US-A- 4 844 604
- US-A- 4 973 611
- US-A- 4 992 524
- US-A- 5 093 386
- US-A- 5 166 186
- CHEMICAL ABSTRACTS, vol. 108, no. 22, May 1988 Columbus, Ohio, US; abstract no. 188526b, YOSHIHARA ET AL: "COATING MATERIALS FOR OPTICAL GLASS FIBERS" page 89; column 2; XP002005502 & JP-A-62 158 142 (NITTO ELECTRIC INDUSTRIAL)
- JOURNAL OF APPLIED POLYMER SCIENCE, vol. 42, no. 7, April 1991, NEW YORK, USA, pages 2039-2044, XP002005501 YU-CHIN LAI ET AL: "SYNTHESIS AND STRUCTURE-PROPERTY RELATIONSHIPS OF UV-CURABLE URETHANE PREPOLYMERS WITH HARD-SOFT-HARD BLOCKS"

## Description

### Field of the Invention

The present invention relates to a liquid curable resin composition which exhibits very little distortion during curing and has high strength, good curing characteristics, and excellent durability, and, in particular, to a liquid curable resin composition which is suitable as a coating material for optical fiber and optical fiber tape core wire, and the like.

### Background of the Invention

Conventionally, an optical fiber is provided with a resin coating comprising a soft primary coating layer on the surface of the optical fiber and a highly rigid secondary coating layer over the surface of the primary coating layer; these layers being applied with the object of protecting and reinforcing the bare optical fiber threads immediately after hot melt spinning of the glass fiber. Then, in order to utilize this coated optical fiber wire in practice, a so called tape structure in which four or eight strands, for example, are combined and secured in parallel on a flat surface to form a tape-like structure with a rectangular cross section is commonly known. The resin composition for forming the primary coating layer is referred to as a soft material; the resin composition for forming the secondary coating layer as a hard material; and the material for joining the optical fiber lines to make tape-structured cores is called a bundling material.

In recent years, with the development of high density optical fiber cables, materials with a higher Young's modulus and high rigidity have been sought as the hard material and the bundling material.

A curable resin used to form these coatings for optical fiber must be a liquid at room temperature and have high processability; must provide good productivity at a high curing rate; must have adequate strength and flexibility; must exhibit very little physical change during temperature changes over a wide range; must have superior heat resistance and superior resistance to hydrolysis; must show superior long term reliability with little changes in its properties over time; must show superior resistance to chemicals such as acids and alkalis; must exhibit low moisture absorption; must exhibit superior light resistance; must exhibit superior oil resistance; and must generate only a low volume of hydrogen gas which adversely affects the optical fiber.

In addition, the hard material and the bundling material used with a high density optical fiber cable must have a Young's modulus of 150 kg/mm² or greater, and must have high tenacity and high rigidity while exhibiting very little distortion during curing.

Specifically, when a thin fiber coating layer is provided for a high density optical fiber, the Young's modulus of the secondary coating layer must be high in order to maintain high quality transmission characteristics in the optical fiber. However, generally, when the resin is designed with a high Young's modulus, not only does the tenacity drops but also the contraction stress due to curing increases, particularly when the liquid curable resin is cured quickly. This contraction stress produces a small amount of distortion in the optical fiber, which causes an increase in the transmission loss through the optical fiber.

Accordingly, a material with a high Young's modulus, low contraction stress, and high tenacity is required as the secondary coating used with a high density fiber cable.

An object of the present invention is to provide an optical fibre coated with a resin composition which has a Young's modulus of 150 kg/mm² or greater and low contraction stress, and which has high tenacity, curability, and reliability.

### Summary of the Invention

The object of the present invention is achieved by the provision of a liquid curable resin composition as defined in claim 1 containing urethane bonds at a concentration of 2.0x10⁻³ mole/gm or more and comprising:
(a) a urethane (meth)acrylate having at least three cyclic structures in the molecule,
(b) a polymerizable mono-functional vinyl monomer of which the homopolymer thereof has a glass transition point of 50°C or higher, and
(c) a polymerization initiator.

### Detailed Description of the Invention

Examples which can be given of a urethane (meth)acrylate with three or more cyclic structures in the molecule, which is component (a) used in the present invention, include a urethane (meth)acrylate with a polyol component which is a polyol with three or more aromatic structures or a polyol with three or more aliphatic structures; a urethane (meth)acrylate with a polyol component which is a polyol with one or more aromatic and/or aliphatic structures in a polyol component using an aromatic and/or an aliphatic diisocyanate in a polyisocyanate component, and the like.

The number average molecular weight of component (a) is preferably 500-2,000. If the molecular weight is less than 500, the cured material becomes too hard, resulting in less expandable product with a greater contraction stress during curing. If the molecular weight is greater than 2,000 on the other hand, the resulting cured resin may have only low hardness.

These urethane (meth)acrylates are manufactured, for example, by reacting a polyol having an aromatic and/or aliphatic structure, an aromatic or aliphatic diisocyanate, and a (meth)acrylate containing a hydroxyl group. Specifically, the isocyanate group of a diisocyanate compound reacts with the hydroxyl group of the polyol and the hydroxyl group of the (meth)acrylate compound to produce the urethane (meth)acrylate.

The reaction may be carried out by a process wherein the polyol, the diisocyanate, and the (meth)acrylate containing a hydroxyl group are reacted together in a block; a process wherein the polyol and the diisocyanate are reacted together and then reacted with the (meth)acrylate containing a hydroxyl group; a process wherein the diisocyanate and the (meth)acrylate containing a hydroxyl group are reacted together and then reacted with the polyol; and a process wherein the diisocyanate and the (meth)acrylate containing a hydroxyl group are reacted together and then reacted with the polyol, and finally again reacting the product with the (meth)acrylate containing a hydroxyl group.

Examples which can be given of a polyol with a cyclic structure used in the present invention include alkyleneoxide-addition diols to bisphenol-A, alkyleneoxide-addition diols to bisphenol-F, hydrogenated bisphenol-A, hydrogenated bisphenol-F, alkyleneoxide-addition diols of hydrogenated bisphenol-A, alkyleneoxide-addition diols of hydrogenated bisphenol-F, alkyleneoxide-addition diols of hydroquinone, alkyleneoxide-addition diols of naphthohydroquinone, alkyleneoxide-addition diols of anthrahydroquinone, 1,4-cyclohexanediol and its alkyleneoxide-addition diols, tricyclodecanediol, tricyclodecanedimethanol, pentacyclodecanediol, pentacyclodecanedimethanol; polyester polyols obtained by reacting a polyvalent alcohol such as ethylene glycol, polyethylene glycol, propylene glycol, polypropylene glycol, tetramethylene glycol, polytetramethylene glycol, 1,6-hexanediol, neopentyl glycol, 3-methyl-1,5-pentanediol, 1,9-nonanediol or 2-methyl-1,8-octanediol, with a polybasic acid, such as phthalic acid, isophthalic acid or terephthalic acid. Among these, alkyleneoxide-addition diols of bisphenol-A and tricyclodecanedimethanol are preferred. Examples of such polyols available commercially include Uniol DA400, DA700, DA1000, DB400, (Nippon Oil and Fats Co., Ltd.) and tricyclodecanedimethanol (Mitsubishi Petrochemical).

The number average molecular weight of these polyols with a cyclic structure is preferably in the 150 to 1,000 range, and most preferably in the 180 to 700 range. If the number average molecular weight is less than 150, the solubility of the polyol in the urethane (meth)acrylate monomer is poor; if greater than 1,000, it is difficult to obtain a Young's modulus for the cured resin greater than 150 kg/mm².

In addition, polyols other than polyols with a cyclic structure can be used in combination as the polyols making up the urethane (meth)acrylate used in the present invention. Examples of such polyols include polyether polyols, polyester polyol, polycarbonate polyols, polycaprolactam polyol, and other polyols without cyclic structures.

Examples of polyether polyols include polyols obtained by ring-opening polymerization or copolymerization of at least one type of compound selected from ethylene oxide, propylene oxide, butylene oxide, tetrahydrofuran, 2-methyl-tetrahydrofuran, 3-methyltetrahydrofuran, substituted tetrahydrofuran, substituted oxetane, tetrahydrofuran, and oxetane. Specific examples include polyethylene glycol, 1,2-polypropylene glycol, 1,3-polypropylene glycol, poly tetramethylene glycol, 1,2-polybutylene glycol, polyisobutylene glycol, copolymers of propylene oxide and tetrahydrofuran, copolymers of ethylene oxide and tetrahydrofuran, copolymers of ethylene oxide and propylene oxide, copolymers of tetrahydrofuran and 3-methyltetrahydrofuran, and copolymers of ethylene oxide and butylene oxide. Examples of such polyols available commercially include Unisafe DC1100, Unisafe DC1800, Unisafe DCB1100, Unisafe DCB1800 (Nippon Oil and Fats Co., Ltd.); PPTG4000, PPTG2000, PPTG1000, PTG2000, PTG3000, PTG650, PTGL2000, PTGL1000 (Hodogaya Chemical Co., Ltd.); EXCENOL4020, EXCENOL3020, EXCENOL2020, EXCENOL1020 (Asahi Glass); PBG3000, PBG2000, PBG1000 and Z3001 (Dai-ichi Kogyo Seiyaku).

Examples which can be given of polyester polyols include polyester polyols obtained by reacting a polyvalent alcohol such as ethylene glycol, polyethylene glycol, propylene glycol, polypropylene glycol, tetramethylene glycol, polytetramethylene glycol, 1,6-hexane diol, neopentyl glycol, 3-methyl-1,5-pentanediol, 1,9-nonanediol, 2-methyl-1,8-octanediol, and the like with a polybasic acid such as maleic acid, fumaric acid, adipic acid or sebacic acid and Kurapol P-2010 (Kuraray).

Examples which can be given of polycarbonate polyols include 1,6-hexanedicarbonate, 1,9-nonanedipolycarbonate, 2-methyl-1,8-octanepolycarbonate, and mixtures of these; and products available on the market, such as DN-980, DN-981, DN-982, DN-983 (manufactured by Nihon Polyurethane Co., Ltd.), PLACCEL-CD205, CD205HL, CD220, (manufactured by Daicel), PC-8000 (manufactured by PPG of the US) or Rurapol PNOC (Kuraray).

Examples of polycaprolactonepolyols include polycaprolactonediols obtained by reacting E-caprolactone with a divalent diol such as ethylene glycol, polyethylene glycol, propylene glycol, polypropylene glycol, tetramethylene glycol, polytetramethylene glycol, 1,2-polybutylene glycol, 1,6-hexanediol, neopentyl glycol, 1,4-butanediol, and the like, as well as PLACCEL-205, 205AL, 212, 212AL, 220 or 220AL (manufactured by Daicel).

Examples of other polyols without a cyclic structure include ethylene glycol, propylene glycol, 1,4-butanediol, 1,5-pentanediol, 1,6-hexanediol, neopentyl glycol, poly-methyl-6-valerolactonepolyol, polybutadiene with a terminal hydroxy group, hydrogenated polybutadiene with a terminal hydroxy group, castor oil-modified polyols, diol compounds with a polydimethylsiloxane terminal group and polydimethylsiloxane carbitol-modified diols.

The number average molecular weight of these polyols is preferably in the 100 to 1,000 range, and most preferably in 200 to 700 range. These polyols are preferably used in combination with the polyols with a cyclic structure mentioned above, and, particularly preferably one mole of these polyols is reacted for one mole of the polyols with a cyclic structure, three moles of diisocyanate and two moles of a (meth)acrylate with a hydroxyl group to produce urethane (meth)acrylate having polyol residual groups with cyclic structures and these polyol residual groups in the same molecule. Examples of desirable polyol compounds among these which can be used together are polytetramethylene glycol with a number average molecular weight between 450 and 650, polycaprolactam diol with a number average molecular weight of 550, for example, PTG450 and PTG650 (Hodogaya Chemical Co., Ltd.), and PLACCEL-205H (manufactured by Daicel).

Examples of diisocyanates include 2,4-tolylene diisocyanate, 2,6-tolylene diisocyanate, 1,3-xylylene diisocyanate, 1,4-xylylene diisocyanate, 1,5-naphthalene diisocyanate, m-phenylene diisocyanate, p-phenylene diisocyanate, 3,3'-dimethyl-4,4'-diphenylmethane diisocyanate, 4,4'-diphenylmethane diisocyanate, 3,3'-dimethylphenylene diisocyanate, 4,4'-biphenylene diisocyanate, 1,6-hexane diisocyanate, isophorone diisocyanate, methylenebis(4-cyclohexyl isocyanate), 2,2,4-trimethylhexamethylene diisocyanate, bis(2-isocyanateethyl)fumarate, 6-isopropyl-1,3-phenyl diisocyanate, 4-diphenylpropane diisocyanate, lysine diisocyanate, hydrogenated diphenylmethane diisocyanate, hydrogenated xylylene diisocyanate, tetramethylxylylene diisocyanate, and the like. In particular, 2,4-tolylene diisocyanate, isophorone diisocyanate, xylylene diisocyanate, and methylenebis(4-cyclohexyl isocyanate), are preferable. Examples of a (meth)acrylate with a hydroxyl group include 2-hydroxyethyl (meth)acrylate, 2-hydroxypropyl (meth)acrylate, 2-hydroxybutyl (meth)acrylate, 2-hydroxy-3-phenyloxypropyl (meth)acrylate, 1,4-butanediol mono(meth)acrylate, 2-hydroxyalkyl(meth)acryloyl phosphate, 4-hydroxycyclohexyl (meth)acrylate, 1,6-hexanediol mono(meth)acrylate, neopentyl glycol mono(meth)acrylate, trimethylolpropane di(meth)acrylate, trimethylolethane di(meth)acrylate, pentaerythritol tri(meth)acrylate, dipentaerythritol penta(meth)acrylate, (meth)acrylates represented by the following formulas (1) and (2),

CH₂=C(R²)COOCH₂CH₂(OCOCH₂CH₂CH₂CH₂CH₂)ₙOH (1)

CH₂=C(R²)-COOCH₂CH(OH)CH₂-O-(C₆H₅) (2)

wherein R² is a hydrogen atom or a methyl group and n is an integer from 1 to 15.

In addition, compounds obtained by an addition reaction between compounds containing a glycidyl group, such as, alkyl glycidyl ether, allyl glycidyl ether, glycidyl (meth)acrylate, or the like, and (meth)acrylic acid can be used. Among these (meth)acrylates with a hydroxyl group, particularly desirable are 2-hydroxyethyl (meth)acrylate or 2-hydroxypropyl (meth)acrylate.

The respective amounts of the polyol, diisocyanate, and (meth)acrylate containing a hydroxyl group which are used are such that 1.1 to 2 equivalents by weight of the isocyanate group contained in a diisocyanate compound and 0.2 to 1.5 equivalents by weight of the hydroxyl group of a (meth)acrylate containing a hydroxyl group are present for one equivalent by weight of the hydroxyl group contained in a polyol. However, it is preferable that the amounts of the hydroxyl groups in the polyol and the acrylate be almost equivalent to the amount of the isocyanate group contained the diisocyanate compound.

In the reaction of these compounds, 0.01 to 1.0 parts by weight of a urethanization catalyst such as copper naphthenate, cobalt naphthenate, zinc naphthenate, n-butyltin-laurate, triethylamine, 1,4-diazobicyclo(2.2.2)octane and 2,6,7-trimethyl-1,4-diazobicyclo(2.2.2)octane, are preferably used to 100 parts by weight of the total reactants used in these reactions. The reaction temperature is normally 10° to 90°C, and preferably 30 to 80°C.

The amount of component (a), urethane (meth)acrylate with three or more cyclic structures in the molecule, contained in the total composition of the present invention is 20 to 85 wt%, but 20 to 70% is considered ideal in maintaining the coating characteristics when covering the optical fiber wire, and in maintaining the flexibility and long term reliability of the coating material after curing.

Also, a urethane (meth)acrylate in which two moles of a (meth)acrylate compound containing a hydroxyl group are reacted with one mole of diisocyanate can be blended into the liquid curable resin composition of the present invention. Examples of such urethane (meth)acrylates include reaction compounds of hydroxyethyl (meth)acrylate and 2,4-tolylene diisocyanate, reaction compounds of hydroxyethyl (meth)acrylate and isophorone diisocyanate, reaction compounds of hydroxypropyl (meth)acrylate and 2,4-tolylene diisocyanate, reaction compounds of hydroxypropyl (meth)acrylate and isophorone diisocyanate, reaction compounds of the compound represented by formula (2) and 2,4-tolylene diisocyanate, reaction compounds of the compound represented by the structural formula (2) and isophorone diisocyanate.

Examples of component (b) of the present invention, which is a polymerizable monofunctional vinyl monomer for which the glass transition point of the homopolymer is 50°C or higher, include lactams containing a vinyl group, such as N-vinyl pyrrolidone and N-vinyl caprolactam; (meth)acrylates containing an alicyclic structure, such as isobornyl (meth)acrylate, bornyl (meth)acrylate, tricyclodecanyl (meth)acrylate, dicyclopentanyl (meth)acrylate, dicyclopentenyl (meth)acrylate or cyclohexyl (meth)acrylate benzyl (meth)acrylate, 4-butylcyclohexyl (meth)acrylate, acryloylmorphorine, vinyl imidazole or vinylpyridine. Among these, lactams containing a vinyl group and (meth)acrylates containing an alicyclic structure are preferable, and, in particular, N-vinyl pyrrolidone, N-vinyl caprolactam, isobornyl (meth)acrylate, and dicyclopentanyl (meth)acrylate, a combination of N-vinyl pyrrolidone and isobornyl (meth)acrylate, and a combination of N-vinyl caprolactam and isobornyl (meth)acrylate are particularly desirable.

The amount of component (b) of the present invention, which is a polymerizable monofunctional vinyl monomer for which the glass transition point of the homopolymer thereof is 50°C or higher, contained in the total composition of the present invention is 15 to 80 wt%, but 20 to 70% is preferable. If less than 15%, the viscosity of the composition is too high and the coating characteristics are poor, and, in addition, the tenacity of the cured material drops and the contraction on curing is too high; if greater than 80%, the curing speed is undesirably low.

Further, in order to increase the Young's modulus and reduce the curing contraction ratio, it is preferable to have a composition mix of 20 to 85% of component (a), 5 to 30% of N-vinyl pyrrolidone or N-vinyl caprolactam, and 10 to 50% of isobornyl (meth)acrylate.

A thermal polymerization initiator or a photopolymerization initiator can be used as component (c), the polymerization initiator, of the present invention.

When the liquid curable resin composition of the present invention is heat cured, a thermal polymerization initiator such as a peroxide or an azo compound is usually used. Specific examples include benzoyl peroxide, t-butyl oxybenzoate and azobisisobutyronitrile.

When the liquid curable resin composition of the present invention is cured by irradiation, a photopolymerization initiator and, as required, a photosensitivity enhancing agent are used. Examples of photopolymerization initiators include 1-hydroxycyclohexylphenyl ketone, 2,2-dimethoxy-2-phenyl acetophenone, xanthone, fluorenone, benzaldehyde, fluorene, anthraquinone, triphenylamine, carbazole, 3-methyl acetophenone, 4-chloro-benzophenone, 4,4'-dimethoxy benzophenone, 4,4'-diamino-benzophenone, Michler's ketone, benzoin propyl ether, benzoin ethyl ether, benzyldimethylketal, 1-(4-isopropyl phenyl)-2-hydroxy-2-methylpropane-1-one, 2-hydroxy-2-methyl-1-phenylpropane-1-one, thioxanthone, diethylthioxanthone, 2-isopropylthioxanthone, 2-chlorothioxanthone, 2-methyl-1-(4-(methylthio)phenyl)-2-morpholinopropane-1-on, 2,4,6-trimethylbenzoyldiphenyl-phosphine oxide, IRUGACURE 184, 651, 500, 907, CG1369, CG24-61 (manufactured by Ciba Geigy), Lucirin LR8728 (manufactured by BASF), Darocurel 116, 1173 (manufactured by Merck) and Ubecryl-P36 (manufactured by the UCB Co.). In addition, examples of photosensitivity enhancing agents are triethylamine, diethylamine, N-methyldiethanolamine, ethanolamine, 4-dimethylaminobenzoic acid, 4-dimethylaminoisomethylbenzoate, 4-dimethyl aminoethylbenzoate, 4-dimethylaminoisoamylbenzoate, and commercial products such as Ubecryl-P102, 103, 104, 105 (manufactured by the UCB Co.) and the like.

When the liquid curable resin composition of the present invention is cured by the combined use of heat and ultraviolet light, a heat polymerization initiator and a photopolymerization initiator can also be jointly used. These polymerization initiators are generally used in an amount of 0.1 to 10% of the total composition, and preferably 0.5 to 7%.

In addition to components (a), (b), and (c), other materials, such as other curable oligomers and polymers, reaction diluents, and other additives may be blended, as required, with the liquid curable resin composition of the present invention in a range in which the characteristics of the present invention are not impaired.

Examples of other curable oligomers and polymers which can be given include polyester (meth)acrylates, epoxy (meth)acrylates, polyamide (meth)acrylates and siloxane polymers containing a (meth)acryloyl oxide group.

Monofunctional compounds and polyfunctional compounds can be used as reaction dilution agents.

Examples of monofunctional compounds which can be given include 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate, t-butyl (meth)acrylate, pentyl (meth)acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, undecyl (meth)acrylate, dodecyl (meth)acrylate, lauryl (meth)acrylate, stearyl (meth)acrylate, tetrahydrofurfuryl (meth)acrylate, butoxyethyl (meth)acrylate, ethoxydiethylene glycol (meth)acrylate, phenoxyethyl (meth)acrylate, polyethylene glycol mono(meth)acrylate, polypropylene glycol mono(meth)acrylate, methoxyethylene glycol (meth)acrylate, ethoxyethyl (meth)acrylate, methoxypolyethylene glycol (meth)acrylate, methoxypolypropylene glycol (meth)acrylate, diacetone (meth)acrylamide, isobutoxymethyl (meth ) acrylamide, N,N-dimethyl (meth)acrylamide, t-octyl (meth)acrylamide, dimethylaminoethyl (meth ) acrylate, diethylaminoethyl (meth)acrylate, 7-amino-3,7-dimethyloctyl (meth)acrylate, N,N-diethyl (meth)acrylamide, N,N-dimethylaminopropyl (meth)acrylamide, hydroxybutyl vinyl ether, lauryl vinyl ether, cetyl vinyl ether, 2-ethylhexyl vinyl ether, and compounds represented by the following formulas (3) to (5).

CH₂=C(R²)-COO(R³O)ₘ-R⁴ (3)

wherein R² indicates a hydrogen atom or a methyl group; R³ is an alkylene group with 2 to 6, preferably 2 to 4, carbon atoms; R⁴ is a hydrogen atom or an alkyl group with 1 to 12, preferably 1 to 9, carbon atoms, and m is an integer from 0 to 12, preferably from 1 to 8. 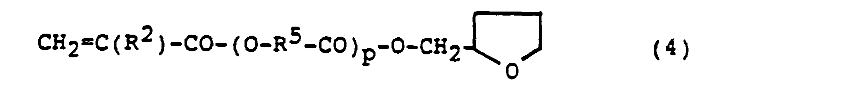 wherein R² is the same as above, R⁵ is an alkylene group with 2 to 8, preferably 2 to 5, carbon atoms, and p is an integer from 1 to 8, preferably from 1 to 4. 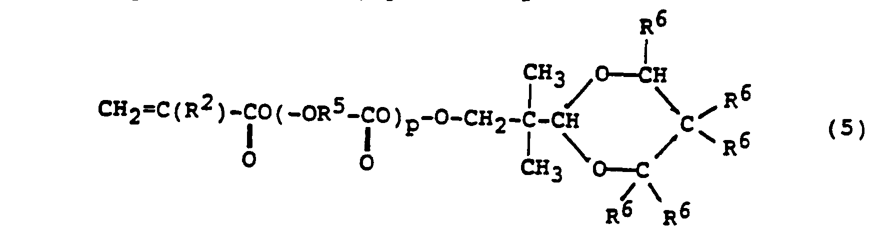 wherein R², R⁵, and p are the same as above, R⁶ is a hydrogen atom or a methyl group.

Examples of commercial products which can be used are ARONIX MI11, MI13, HI 14, M117, (manufactured by Toagosei Chemical Industry), TC110S, R629, R644 (manufactured by Nippon Kayaku) and BISCOT 3700 (manufactured by Osaka Organic Chemicals).

Examples of polyfunctional compounds include trimethylolpropane tri(meth)acrylate, pentaerythritol tri(meth)acrylate, ethylene glycol di(meth)acrylate, tetraethylene glycol di(meth)acrylate, polyethylene glycol di(meth)acrylate, 1,4-butanediol di(meth)acrylate, 1,6-hexanediol di(meth)acrylate, neopentyl glycol di(meth)acrylate, trimethylolpropanetrioxydiethyl (meth)acrylate, tris(2-hydroxyethyl)isocyanurate tri(meth)acrylate, tris(2-hydroxyethyl)isocyanurate di(meth)acrylate, tricyclodecanedimethanol di(meth)acrylate, epoxy (meth)acrylates which are (meth)acrylate addition compounds of diglycidyl ethers of bisphenol-A or triethylene glycol divinyl ether. Also, examples of commercial products which can be used are UPIMA-UV SA1002, SA2007 (manufactured by Mitsubishi Petrochemicals), BISCOAT 700 (manufactured by Osaka Organic Chemicals), EAYAAAD R604, DPCA-20, DPCA-30, DPCA-60, DPCA-120, Mx-620, D-310, D-330 (manufactured by Nippon Kayaku), ARONIX M210, M2I5, M315 and M325 (manufactured by Toagosei Chemical Industry).

Particularly desirable among these examples are tricyclodecanedimethanol di(meth)acrylate (YUPINA-UV SA1002) and BISCOAT 700.

Other additives which can, as required, be blended into the resin composition for coating optical fiber of the present invention include, for example, antioxidants, colorants, ultraviolet absorbents, photostabilizers, silane coupling agents, thermal polymerization inhibitors, leveling agents, surfactants, storage stabilizers, plasticizers, lubricants, solvents, fillers, age resistors, wettability agents or coated surface improvers. Commercial antioxidants which can be used are Irganox 1010, 1035, 1076, 1222 (manufactured by Ciba Geigy) or Antigen P, 3C, FR (manufactured by Sumitomo Chemical). Commercial ultraviolet absorption agents include Tinuvin P234, 320, 326, 327, 328, 329, 213 (manufactured by Ciba Geigy), Seesorb 102, 103, 501, 202, 712 and 704 (manufactured by Cypro Chemical). Commercial photostabilizers include Tinuvin 292, 144, 622LD (manufactured by Ciba Geigy), Sanol LS770 (manufactured by Sankyo Chemical), Sumisorb TM-061 (manufactured by Sumitomo Chemical), and the like. Examples of silane coupling agents which can be given are γ-aminopropyl triethoxysilane, γ-mercaptopropyl trimethoxysilane, γ-methacryloxypropyl trimethoxysilane, and commercial products such as 5H6062, 6030 (manufactured by Toray Silicone), EBE903, 603 and 403 (manufactured by Shin-etsu Chemical).

The urethane concentration among the components of the liquid curable resin composition of the present invention is 2.0 x 10⁻³ moles/gm or greater. A concentration smaller than 2.0 x 10⁻³ moles/gm is undesirable, because the Young's modulus of the cured material is not as high as 150 kg/mm². A urethane concentration is also undesirable because of an increase in the viscosity of the resulting composition. A preferable urethane concentration is from 2.0 x 10⁻³ to 3.0 x 10⁻³ moles/gm.

The viscosity of the liquid curable resin composition of the present invention is normally in the 200 to 20,000 cp range at 25°C, and is preferably 2,000 to 10,000 cp/25°C. When the liquid curable resin composition of the present invention is used as a secondary covering material for an optical fiber elemental wire or as a bundling material for a core wire, the Young's modulus of the cured composition is preferably 150 to 250 kg/mm² and more preferably 180 to 240 kg/mm².

The liquid curable resin composition of the present invention can be cured by heat and/or irradiation. Here, irradiation means infrared rays, visible light, ultraviolet rays, x-ray, electron rays, α-rays, β-rays, and γ-rays.

### Examples

The present invention will be illustrated in more detail in the following description of exemplary embodiments which are given for illustration of the invention and are not intended to be limiting thereof.

### Example 1

806 gm of isobornyl acrylate, 1,156 gm of 2,4-tolylene diisocyanate, 2.4 gm of dibutyltindilaurate, and 1 gm of 2,6-di-t-butyl-4-methylphenol as a polymerization inhibitor, and 0.2 gm of phenothiazine were charged to a reaction vessel equipped with a stirrer. After cooling with ice water to 10°C, 651 gm of hydroxyethyl acrylate was added while controlling the temperature to 20°C or lower. After this addition was completed, the mixture was further stirred for one hour at 10 to 20°C, and 544 gm of tricyclodecanedimethanol (Mitsubishi petrochemical) and 670 gm of polytetramethylene glycol with a number average molecular weight of 650 (PTG650; Hodogaya Chemical Co., Ltd.) were added while maintaining the temperature at 50°C or below. The mixture was then stirred for 5 hours at 50 to 60°C to complete the reaction, thus obtaining 3,830.6 gm of a mixture of a urethane acrylate with three or more cyclic structures in the molecule and a number average molecular weight of 1,075 (79%) and isobornyl acrylate (21%).

To the above mixture, 806 gm of isobornyl acrylate, 864 gm of N-vinyl pyrrolidone, 83 gm of 2,4,6-trimethylbenzoyl-diphenyl phosphine oxide (Lucirin LR8728 manufactured by BASF), and 17 gm of Irganox 1035 (manufactured by Ciba Geigy) were added, and the mixture was stirred for 3 hours at 45 to 55°C to obtain 5,600.6 gm of the liquid curable resin composition of the present invention. The concentration of urethane bonded to the resulting components was 2.23 x 10⁻³ moles/gm.

### Example 2

715 gm of isobornyl acrylate, 1,365 gm of isophorone diisocyanate, 4.4 gm of butyltindilaurate, 1.3 gm of 2,6-di-t-butyl-4-methylphenol, and 0.4 gm of phenothiazine were charged to a reaction vessel equipped with a stirrer. After cooling with ice water to 10°C, 549 gm of hydroxyethyl acrylate was added while controlling the temperature to 20°C or lower. After this addition was completed, the mixture was further stirred for one hour at 10 to 20°C, and 459 gm of tricyclodecanedimethanol and 922 gm of polytetramethylene glycol with a number average molecular weight of 650 were added while maintaining the temperature at 50°C or below. The mixture was then stirred for 5 hours at 50 to 60°C to complete the reaction to obtain 4,016.1 gm of a mixture of a urethane acrylate with three or more cyclic structures in the molecule and a number average molecular weight of 1,390 (82%) and isobornyl acrylate (18%).

To this mixture, 715 gm of isobornyl acrylate, 770 gm of N-vinyl pyrrolidone, 83 gm of 2,4,6-trimethylbenzoyl-diphenylphosphine oxide, and 17 gm of Irganox 1035 (manufactured by Ciba Geigy) were added, and the mixture was stirred for 3 hours at 45 to 55°C to obtain 5,601.1 gm of the liquid curable resin composition of the present invention. The concentration of urethane bonded to the resulting components was 2.20 x 10⁻³ moles/gm.

### Example 3

300 gm of tricyclodecanedimethanol diacrylate (UPIMASA1002; manufactured by Mitsubishi Petrochemicals), 1,021 gm of 2,4-tolylene diisocyanate, 1.4 gm of dibutyltindilaurate, 0.7 gm of 2,6-di-t-butyl-4-methylphenol, and 0.2 gm of phenothiazine were charged to a reaction vessel equipped with a stirrer. After cooling with ice water to 10°C, 1,038 gm of hydroxyethyl acrylate was added while controlling the temperature to 20°C or below. After this addition was completed the mixture was further stirred for one hour at 10 to 20°C, and 340 gm of an ethyleneoxide-added diol of bisphenol-A with a number average molecular weight of 400 (UNZOL DA400; Nippon Oil and Fats Co., Ltd.) and 353 gm of polytetramethylene glycol with a number average molecular weight of 650 (PTG650; Hodogaya Chemical Co., Ltd.) were added while maintaining the temperature at 50°C or below. The mixture was then stirred for 5 hours at 50 to 60°C to complete the reaction, thus obtaining 3,054.3 gm of a mixture of a urethane acrylate with three or more cyclic structures; a urethane acrylate with a number average molecular weight of 980 which is a reaction product of tolylene isocyanate and hydroxyethyl acrylate on the two ends of the ethyleneoxide-added diol of bisphenol-A with a number average molecular weight of 400 (27%); a urethane acrylate with a number average molecular weight of 1,130 which is a reaction product with tolylene diisocyanate and hydroxyethyl acrylate on the two ends of the polytetramethylene glycol with a number average molecular weight of 650 (22%); a urethane acrylate which is a reaction product of 2 moles of hydroxyethyl acrylate and 1 mole of tolylene diisocyanate (41%); and isobornyl acrylate (10%).

To this mixture, 1,450 gm of tricyclodecanedimethanol acrylate, 650 gm of isobornyl acrylate, 350 gm of N-vinyl pyrrolidone, 75 gm of 2,4,6-trimethylbenzoyldiphenyl-phosphine oxide, 15 gm of benzophenone, and 15 gm of Irganox 1035 (manufactured by Ciba Geigy) were added, and the mixture was stirred for 3 hours at 45 to 55°C to obtain 5,609.3 gm of the liquid curable resin composition of the present invention. The concentration of urethane bonded to the resulting components was 2.30 x 10⁻³ moles/gm.

### Comparative Example 1

1,648 gm of 2,4-tolylene diisocyanate, 5 gm of butyltindilaurate, 1.5 gm of 2,6-di-t-butyl-4-methylphenol, and 1,155 gm of tricyclodecanedimethanol diacrylate were charged to a reaction vessel equipped with a stirrer. After cooling with ice water to 10°C, 2,197 gm of hydroxyethyl acrylate was added while controlling the temperature to 50°C or below. After this addition was completed, the mixture was further stirred for five hours at 50 to 60°C to complete the reaction, thus obtaining 5,006.3 gm of a mixture of a urethane acrylate with one cyclic structure; a urethane acrylate which is a reaction product of 2 mols of hydroxyethyl acrylate to 1 mol of tolylene diisocyanate (77%); and tricyclodecanedimethanol diacrylate (23%).

To this mixture, 495 gm of N-vinyl pyrrolidone, 83 gm of 2,4,6-trimethylbenzoyldiphenylphosphine oxide, and 17 gm of Irganox 1035 (manufactured by Ciba Geigy) were added, and the mixture was stirred for 3 hours at 45 to 55°C to obtain 5,601.3 gm of a liquid curable resin composition. The concentration of urethane bonded to the resulting components was 3.38 x 10⁻³ moles/gm.

### Comparative Example 2

806 gm of isobornyl acrylate, 855 gm of 2,4-tolylene diisocyanate, 2.4 gm of dibutyltindilaurate, 1 gm of 2,6-di-t-butyl-4-methylphenol, and 0.2 gm of phenothiazine were added to a reaction vessel equipped with a stirrer. After cooling with ice water to 10°C, 570 gm of hydroxyethyl acrylate were charged while controlling the temperature to 20°C or below. After this addition was completed, the mixture was further stirred for one hour at 10 to 20°C, and 1,596 gm of polytetramethylene glycol with a number average molecular weight of 650 (PTG650; Hodogaya Chemical Co., Ltd.) was added while maintaining the temperature at 50°C or below. The mixture was then stirred for 5 hours at 50 to 60°C to complete the reaction, thus obtaining 3,830.6 gm of a mixture of a urethane acrylate reacted with tolylene isocyanate and hydroxyethyl acrylate on the two ends of the polytetramethylene glycol with a number average molecular weight of 650 (79%); and isobornyl acrylate (21%).

To this mixture, 806 gm of isobornyl acrylate, 864 gm of N-vinyl pyrrolidone, 83 gm of 2,4,6-trimethylbenzoyl-diphenylphosphine oxide, and 17 gm of Irganox 1035 (manufactured by Ciba Geigy) were added, and the mixture was stirred for 3 hours at 45 to 55°C to obtain 5,600.6 gm of a liquid curable resin composition. The concentration of urethane bonded to the resulting components was 1.75 x 10⁻³ moles/gm.

### Test Examples

A film test and a drawing test were carried out for each liquid curable resin composition prepared as Examples 1 to 3 and Comparative Examples I and 2. The results are given in Table 1.

### Film tests

### 1. Preparation of Test Leaf

Using a 381 *µ*m thick applicator, each of the various liquid composition's were applied to glass plates, and cured films of a thickness of 250 *µ*m were obtained by irradiation with ultraviolet rays at 500 mJ/cm². Next, the cured films were peeled from the glass plate and tempered for 24 hours at a temperature of 23°C and 50% RH, to obtain the test leaves.

### 2. Measurement of tensile characteristics

Tension tests were carried out using a No. 2 dumbbell to conform to JIS K7113. The Young's modulus was measured at a drawing speed of 1 mm/min, and the breaking strength and breaking elongation were measured at 50 mm/min.

### Drawing tests

Using an optical fiber drawing machine, one layer of a composition was applied to copper wire and then cured by irradiation with ultraviolet rays to obtain a copper wire coated with resin. The diameter of the copper wire core material of the coated copper wires was 130 *µ*m, and of the covered wire 190 *µ*m; the thickness of the covering film being 30 *µ*m. The covered copper wire was prepared at a drawing speed of 360 m/min. A macaroni-like test material was obtained by extracting the copper wire, and the following tests were performed.

### 1. Measurement of Young's modulus

The hollow, cured material was used as a test leaf. This hollow, cured material was threaded through holes in two circular aluminum plates with an opening and fixed with an instantaneous adhesive, with a space between the plates being 25 mm. Tension tests were carried out by pulling the two circular plates apart using a chuck. Other than using the hollow, cured material as a test leaf and using a tool as a chuck for clamping and pulling the two circular plates, the test conformed to JIS K7113.

### 2. Measurement of curing contraction ratio

The curing contraction ratio was obtained from the following equation, in which ri and r2 are the densities at 25°C of the composition and the cured material respectively. Curing contraction ratio (%) = (1 - r₁/r₂) x 100.

**TABLE 1**

| | Examples | | | Comparative Examples | |
|---|---|---|---|---|---|
| Evaluation Item | 1 | 2 | 3 | 1 | 2 |
| Film Test (Drawing characteristics) | | | | | |
| Young's modulus (kg/mm) | 170 | 160 | 180 | 180 | 40 |
| Breaking strength (kg/mm²) | 6.8 | 6.5 | 6.9 | 5.0 | 3.5 |
| Breaking elongation (%) | 12 | 13 | 10 | 3 | 60 |

| Drawing Test | | | | | |
|---|---|---|---|---|---|
| Young's modulus (kg/mm²) | 230 | 210 | 240 | 230 | 50 |
| Cure contraction rate (%) | 5.6 | 5.4 | 6.0 | 9.5 | 5.0 |

The liquid curable resin composition of the present invention exhibits low contraction stress at a high Young's modulus, and has high tenacity, curability, and reliability, and is therefore a particularly superior coating material for optical fiber. In addition, because this composition has a high Young's modulus and high tenacity, it is suitable as a protective coating material for all types of substrates such as, for example, metal, plastic, wood, ceramics, glass, and the like.

## Claims

1. An optical fiber coated with a secondary coating and/or a bundling material wherein the secondary coating and/or bundling material is a cured layer obtained from a liquid curable resin composition containing urethane bonds at a concentration of 2.0x10⁻³ mole/gm or more and comprising:
a) 20 to 85 wt% urethane (meth)acrylate having at least three cyclic structures in the molecule;
b) 15 to 80 wt% polymerizable mono-functional vinyl monomer of which the homopolymer thereof has a glass transition point of 50°C or more; and
c) 0.1 to 10 wt% polymerization initiator,
wherein the weight percentages of the compounds (a)-(c) are related to the total compositions, and add up to a total of 100%.

2. An optical fiber according to claim 1, wherein the urethane (meth)acrylate component comprises a polyol component selected from the group of polyols with a cyclic structure, polyether polyols, polyester polyols, polycarbonate polyols and polycaprolactam polyols.

3. An optical fiber according to anyone of claims 1-2, wherein the urethane (meth)acrylate has a number average molecular weight in the range of from 500 to 2000.

4. An optical fiber according to anyone of claims 1-3, wherein the monofunctional vinyl monomer is selected from the group of lactams, (meth)acrylates containing an alicyclic structure; benzyl (meth)acrylate, 4-butylcyclohexyl (meth)acrylate, acryloylmorphine, vinyl imidazole and vinyl pyridine.

5. An optical fiber according to anyone of claims 1-4, wherein the polymerization initiator is a thermal polymerization initiator.

6. An optical fiber according to anyone of claims 1-4, wherein the polymerization initiator is a photopolymerisation initiator.

7. An optical fiber according to anyone of claims 1-6, wherein the liquid curable resin composition further comprises at least one of other curable oligomers and polymers, reaction diluents, antioxidants, colorants, ultraviolet absorbents, photostabilizers, silane coupling agents, thermal polymerization inhibitors, leveling agents, surfactants, storage stabilizers, plasticizers, lubricants, solvents, fillers, age resistors and wettability agents.

## Patentansprüche

1. Lichtleitfaser, beschichtet mit einer sekundären Beschichtung und/oder einem Bündelungsmaterial, wobei die sekundäre Beschichtung und/oder das Bündelungsmaterial eine gehärtete Schicht darstellt, erhalten aus einer flüssigen, härtbaren Harzzusammensetzung, die Urethanbindungen in einer Konzentration von 2,0 x 10⁻³ Mol/g oder mehr enthält und umfasst:
a) 20 bis 85 Gewichtsprozent Urethan(meth)acrylat mit mindestens drei cyclischen Strukturen in dem Molekül;
b) 15 bis 80 Gewichtsprozent polymerisierbares, monofunktionelles Vinylmonomer, wobei das Homopolymer davon einen Glasübergangspunkt von 50°C oder mehr aufweist; und
c) 0,1 bis 10 Gewichtsprozent Polymerisationsstarter,
wobei die Gewichtsprozentsätze der Verbindungen (a) - (c) sich auf die Gesamtzusammensetzungen beziehen und sich zu insgesamt 100% summieren.

2. Lichtleitfaser nach Anspruch 1, wobei die Urethan(meth)acrylatkomponente eine Polyolkomponente, ausgewählt aus der Gruppe von Polyolen mit einer cyclischen Struktur, Polyetherpolyolen, Polyesterpolyolen, Polycarbonatpolyolen und Polycaprolactampolyolen, umfasst.

3. Lichtleitfaser nach einem der Ansprüche 1-2, wobei das Urethan(meth)acrylat ein zahlenmittleres Molekulargewicht im Bereich von 500 bis 2000 aufweist.

4. Lichtleitfaser nach einem der Ansprüche 1-3, wobei das monofunktionelle Vinylmonomer aus der Gruppe von Lactamen, (Meth)acrylaten, die eine alicyclische Struktur enthalten; Benzyl(meth)acrylat, 4-Butylcyclohexyl(meth)-acrylat, Acryloylmorpholin, Vinylimidazol und Vinylpyridin ausgewählt ist.

5. Lichtleitfaser nach einem der Ansprüche 1-4, wobei der Polymerisationsstarter ein thermischer Polymerisationsstarter ist.

6. Lichtleitfaser nach einem der Ansprüche 1-4, wobei der Polymerisationsstarter ein Photopolymerisationsstarter ist.

7. Lichtleitfaser nach einem der Ansprüche 1-6, wobei die flüssige härtbare Harzzusammensetzung weiterhin mindestens eines von anderen härtbaren Oligomeren und Polymeren, Reaktionsverdünnungsmitteln, Antioxidantien, färbenden Mitteln, Ultraviolettlichtabsorptionsmitteln, Photostabilisatoren, Silanhaftmitteln, thermischen Polymerisationsinhibitoren, Nivelliermitteln, Tensiden, Lagerungsstabilisatoren, Weichmachern, Gleitmitteln, Lösungsmitteln, Füllstoffen, Alterungsverzögerungsmitteln und Netzmitteln umfasst.

## Revendications

1. Une fibre optique revêtue d'une couche secondaire et/ou d'un matériau de bottelage, dans laquelle la couche secondaire ou le matériau de bottelage est une couche durcie obtenue à partir d'une composition de résine liquide durcissable qui renferme des liaisons uréthane à une concentration de 2,0 x 10⁻³ mole/g ou plus et qui comporte :
a) de 20 à 85 % en poids de (méth)acrylate d'uréthane ayant au moins trois structures cycliques dans la molécule ;
b) de 15 à 80 % en poids de monomère vinylique monofonctionnel, polymérisable, dont l'homopolymère présente un point de transition vitreuse de 50°C ou plus ; et
c) de 0,1 à 10 % en poids d'un initiateur de polymérisation dans lequel les pourcentages pondéraux des composés (a)-(c) sont rapportés à la composition totale, et ajoutés jusqu'à un total de 100 %.

2. Une fibre optique selon la revendication 1, dans laquelle le composant(méth) acrylate d'uréthane comporte un composant polyol choisi dans le groupe des polyols présentant une structure cyclique, les polyéther polyols, les polyester polyols, les polycarbonates polyols et les polycaprolactame polyols.

3. Une fibre optique selon l'une quelconque des revendications 1-2, dans laquelle le (méth)acrylate d'uréthane présente un poids moléculaire moyen en nombre dans la gamme de 500 à 2000.

4. Une fibre optique selon l'une quelconque des revendications 1-3, dans laquelle le monomère vinylique monofonctionnel est choisi dans le groupe des lactames, des (méth)acrylates renfermant une structure alicyclique, du (méth)acrylate de benzyle, du (méth)acrylate de 4-butylcyclohexyle, de l'acryloylmorphine, du vinyl imidazole et de la vinyl pyridine.

5. Une fibre optique selon l'une quelconque des revendications 1-4, dans laquelle l'initiateur de polymérisation est un initiateur de polymérisation thermique.

6. Une fibre optique selon l'une quelconque des revendications 1-4, dans laquelle l'initiateur de polymérisation est un initiateur de photopolymérisation.

7. Une fibre optique selon l'une quelconque des revendications 1-6, dans laquelle la composition de résine liquide durcissable comporte en outre au moins un parmi les autres oligomères et polymères durcissables, des agents diluants de réaction, des agents antioxydants, des colorants, des agents absorbant l'ultra-violet, des agents photostabilisants, des agents de couplage à base de silane, des inhibiteurs de polymérisation thermique, des agents d'égalisation, des agents tensioactifs, des stabilisateurs de stockage, des agents plastifiants, des lubrifiants, des solvants, des charges, des agents de résistance au vieillissement et des agents de mouillabilité.
